# EUROPEAN PATENT SPECIFICATION

(11) **EP 1 653 475 B1**
(45) Date of publication and mention of the grant of the patent: **01.08.2007**
(21) Application number: 05256676.7
(22) Date of filing: 27.10.2005
(51) Int. Cl.: G11C 11/56

(54) **Multi-bit magnetic random access memory device and method for writing the same**
Magnetische Multibit-Direktzugriffspeicheranordnung und deren Schreibverfahren
Dispositif de mémoire magnétique à accès aléatoire multi-bits et son procédé d'écriture

(30) Priority: 27.10.2004 KR 2004086392; 29.04.2005 US 117453
(43) Date of publication of application: 03.05.2006
(73) Proprietor: Samsung Electronics Co., Ltd., Suwon-si, Gyeonggi-Do (KR)
(72) Inventor: Lim, Chee-kheng, Samsung Adv. Institute of Techn., Yongin-si, Gyeonggi-do (KR)
(74) Representative: Greene, Simon Kenneth

(56) References cited:
- EP-A- 1 398 835
- EP-A- 1 600 977
- US-A- 6 005 800
- US-A1- 2003 209 769
- US-B1- 6 700 720

## Description

### CROSS-REFERENCE TO RELATED APPLICATIONS

This application claims priority from Korean Patent Application No. 2004-0086392 filed October 27, 2004.

### BACKGROUND OF THE INVENTION

### 1. Field of the Invention

The present invention relates to magnetic random access memory, and more particularly to an advanced multi-bit magnetic random access memory device and methods for operating and manufacturing the advanced multi-bit magnetic random access memory device.

### 2. Description of the Related Art

Rapid growth in digital information generation is likely to face a new wave of explosion in high density memory demand due to the growing popularity of mobile devices. Magnetic random access memory (MRAM) is one of the most promising candidates to provide energy efficient and non-volatile memories.

The most attractive advantages ofMRAM are that the mobile device retains the current state of work when powered down, and, additionally, longer battery run-times can be provided for mobile devices from notebook computer to cell-phones, since non-volatility enables MRAM chips to consume less power than conventional Dynamic Random Access Memory (DRAM) and Static Random Access Memory (SRAM). MRAM operates on the principle of storing data bits using magnetic charges instead of electrical charges as used by DRAM and SRAM

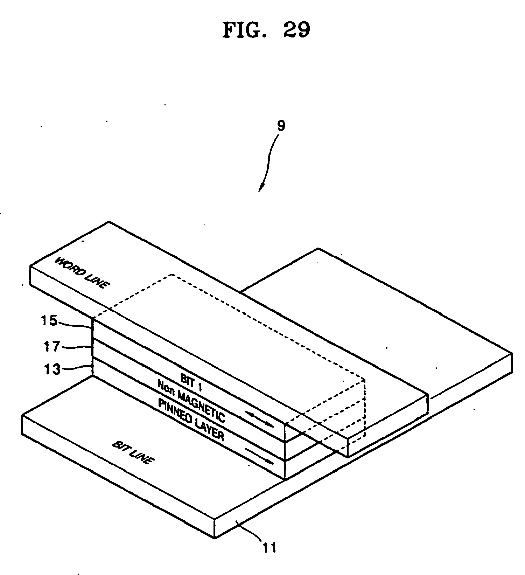

In the related art, an MRAM is known where one bit of information is stored in a magnetic multilayer cell, which comprises both magnetic and non-magnetic layers. As shown in FIG. 29 in its simplest form, a magnetic multilayer memory cell 9 includes four layers. These layers include an antiferromagnetic layer 11, and two ferromagnetic layers 15,13 separated by a non-magnetic spacer layer 17e

The non-magnetic spacer layer 17 may either be conductive or non-conductive. In a memory having a conductive spacer, a spin-valve element is created, while a memory having a non-conductive spacer layer produces a magnetic tunnel junction (MTJ) magnetoresistive element.

One of the ferromagnetic layers 13 is exchange-coupled to the antiferromagnetic layer 11, effectively pinning the orientation of magnetization in the ferromagnetic layer 13. This ferromagnetic layer 13 is known as the pinned layer.

When an external magnetic field is applied to such a cell, the magnetization of the other ferromagnetic layer 15 the so-called free layer (the non-pinned layer), will react to the field.

Sensing or reading the information stored in the cell is based on a magnetoresistance effect.

The electrical resistance of such a multilayer cell 9 depends on the relative orientation of the magnetization in the two ferromagnetic layers 15.13. In this case, there is low resistance when both magnetization orientations are in parallel (P) alignment and high resistance when they are in antiparallel (AP) alignment.

The building block of the MRAM architecture is its crossed-wires structure, where a magnetic element is located at the intersection point of two orthogonal wires. The writing or addressing process of an MRAM cell is accomplished by applying two orthogonal magnetic field pulses, generated by sending an electrical current, down the wires. The two wires are often referred to as the word line (Hy field, along the short axis of the magnetic element) and the bit line (Hx field, along the long axis (or easy axis) of the magnetic element).

The strength of the magnetic fields applied are such that one field alone cannot switch the magnetization of a magnetic element, but rather it requires the combination of both magnetic fields from the word and bit lines, for cell selectivity. However, the present cell writing technology relies on applying a long magnetic field pulse, tens of nanoseconds, long enough for the magnetization to reach the final equilibrium state. This method of writing is also known as the quasistatic writing which is not only slow, but also not energy efficient.

Also, in such a memory having a multilayer cell structure, there is a limitation of memory density. In most cases, only one bit of information can be stored at the cross-point (the intersection point of the two orthogonal wires) in the MRAM architecture.

Recent attempts have been made to overcome this limitation of memory density. For example, U.S. Patent Publication 2003/0209769 to Nickel et aL discloses an MRAM device having a multi-bit memory cell. In particular, each memory cell includes two magnetoresistive devices connected in series.

Each of the two magneto-resistive devices has sense layers with distinctly different coercivities and, therefore, requires different writing currents. Thus, write operations can be performed selectively on the two magneto-resistive devices. Each multi-bit memory cell has four logic states with different resistance values in each state. This allows for storage of more data than a related art single-bit memory cell, which has only two logic states.

U.S. Patent No. 5,930,164 to Zhu also discloses a magnetic memory device having four logic states and an operating method thereof. The memory device of Zhu includes a multi-bit system accomplished by stacking two or more memory cells on top of each other separated by a thick conductive layer to prevent magnetic coupling between memory cells.

In Zhu, each memory cell comprises a free magnetic data layer to store one bit of information, a hard magnetic layer as a reference layer, and a barrier layer between the free and hard magnetic layer. Essentially, each memory cell is an independent MTJ device. The memory cells have distinct coercivities, therefore allowing independent cell writing by one or two magnetic fields. For sensing or reading process, these memory cells have different Magnetoresistance (MR) ratios, therefore creating four resistance states for sensing of multi-bit information. The writing method, however, relies on a quasistatic writing method which is not only slow, but also not energy efficient.

U.S. Patent No. 5,703,805 to Tehrani et aL discloses a method for detecting information stored in an MRAM cell having two magnetic layers with different thicknesses.

In the Tehrani et aL device, there are two magnetic data layers separated by a non-magnetic spacer. Each magnetic data layer can store one bit of information. A writing process for this device uses differing coercive forces for the two magnetic data layers, hence, independent writing is possible using a quasistatic method. A quasistatic writing method relies on applying a long magnetic field pulse of several nanoseconds that is long enough for the magnetization of a cell to reach a final equilibrium state. As noted above, this method nf switching is not only slow, but also not energy efficient.

Further, the reading process of the Tehrani et al. device is very complex since six magnetic fields are required to determine the state in each data layer separately. This creates a slow and inefficient reading process.

Finally, U.S. Patent No. 6,590,806 to Bhattacharyya discloses a device having two magnetic data layers separated by a pair of antiferromagnetically coupled magnetic layers. The two free magnetic data layers have distinct coercivities and hence, independent writing is possible.

The Bhattacharyya device has four resistance states depending on the magnetic configuration of the free data layers to the antiferromagnetically coupled layers. Therefore, the reference layer for the magnetoresistance effect are the pair of antiferromagnetic coupled layers. This means that if this device is to be used for additional data layers, each data layer requires one pair of antiferromagnetic layers, providing for a complicated device structure. Also, the device relies on the conventional quasistatic writing method.

Further, the manufacturing process of related art MRAM devices has only been known to produce low yields of the memory due to high sensitivity to cell defects, which causes domain nucleation, and hence, wide switching field distribution.

US 6,005,800 describes a magnetic memory array with cells of two types of shapes. The cells are arranged as a checkerboard pattern so that adjacent cells are of opposite shape to reduce the likelihood of writing to a neighbouring cell during a write operation.

US 2003/0209769 describes a magnetic memory cell with two stacked MR devices at a single word-line/bit line crossing point.

EP 1,398,835 describes a magnetic memory array in which cells are stacked. Adjacent cells, horizontally, vertically or both, may be oriented in different directions.

EP 1 600 977 was published on 30 November 2005 and accordingly represents prior art under Article 54(3) EPIC. A multi-bit stack is provided at the crossing points between word and bit lines.

### SUMMARY OF THE INVENTION

Illustrative, non-limiting embodiments of the present invention overcome the above disadvantages and other disadvantages not described above. Also, the present invention is not required to overcome the disadvantages described above, and an illustrative, non-limiting embodiment of the present invention may not overcome any of the problems described above.

According to an aspect of the present invention, a multi-bit MRAM device is provided according to claim 1.

More particularly, in an exemplary embodiment of the present invention, the magnetic memory comprises one or more pair-cells, each pair-cell comprising two memory cells, and each memory cell having a magnetic multilayer structure. The multilayer structure of each memory cell comprises a magnetically changeable ferromagnetic layer, a ferromagnetic reference layer having a non-changeable magnetization state, and a corresponding spacer layer separating the ferromagnetic layers. Further, the memory cells are arranged or shaped such that an effective remnant magnetization of each of the cells is non-parallel from the long axis of the cells (i.e., the remnant magnetization of each of the cells is not parallel to one other).

The memory may allow for fast and efficient switching. This may be accomplished by spin precessional switching. Except for high operation frequencies, spin precessional switching is energy efficient because it requires a lower switching field as compared to the aforementioned quasistatic writing process. Shorter field pulses further reduce power consumption.

According to another aspect of the present invention, a writing method is provided according to claim 33.

The writing scheme in one of the embodiments of the invention uses the spin precessional nature of ferromagnetic material in which an easy axis magnetic field (+Hx or -Hx) used to define the final state of the memory (1 or 0) is combined with an orthogonal hard axis excitation field (+Hy or -Hy) to initiate spin precession. In this switching process, the Hx or Hy field alone is not able to switch the magnetization. Rather, the combination of the Hx and Hy fields is the essence of selective writing in the memory array. Spin precessional switching as used in the invention preferably uses a fast rising Hy field, in the order of 0.5 ns or less.

In an exemplary embodiment of the invention, the Hy excitation field pulse is required to have a very short rise time (< 0.5 ns) and pulse duration is of the half the magnetic spin precession period.

The pair of memory cells can either have individual CMOS or shared CMOS for separated reading of stored information.

Ultra-fast magnetization switching dynamics is governed by the damped precession of magnetization about an effective magnetic field, H*_{eff}*. The effective magnetic field H*_{eff}* is the sum of the applied fields and the magnetic anisotropy field of the memory cell which is dominated by the shape anisotropy.

The motion of magnetization M is described by the Landau-Liftshitz-Gilbert (LLG) equation, dM/dt = -γ (M x *H_{eff})* + (α / Ms)(M x dM/dt), where M is the magnetization vector, γ is the gyro-magnetic constant, α is the phenomenological Gilbert damping constant, and Ms is the saturation magnetization. In the case of MRAM, the effective applied magnetic field is the vector sum of the Hx and Hy.

A fast rising magnetic field pulse applied orthogonal to the M direction will generate a large torque, γ(M x H*_{eff}*). As a result, M is excited into precession around the effective field direction. The first term in the LLG equation is the precession term, which describes the spin precession, and the second term is the energy dissipation term that dictates the rate of energy dissipation. Adapting spin precessional switching promises high-energy efficiency as well as an ultrafast switching speed.

One of the most important natures in precessional switching of the invention is that the precession frequency f depends on the effective magnetization and effective applied magnetic field. It can be expressed was *f*² = (γ/2π)² (*H_{eff}* + *M_{eff})* + *H_{eff},* where γ = 28 GHz/T. This is also known in the art as the Kittel formula. The equation leads to the fact that it is possible to manipulate the spin precession frequency by controlling the effective magnetization and effective field experienced by the spin.

Accordingly, a writing method according to an exemplary embodiment of the invention, for a magnetic memory comprises applying a first magnetic field below a switching field of a pair-cell along the long axis (a bit line) of the memory cells; and applying a second magnetic field orthogonal to the first magnetic field, the second magnetic field having a strength sufficient (for example, stronger than the first magnetic field) to create a spin precession angle large enough to switch magnetization of one memory cell of the pair-cell to an opposite direction but not enough strength to switch the magnetization of the other cell of the pair-cell.

The second magnetic field is turned-off as soon as the magnetization of the one cell has precessed to more than about 1/2 but less than about 3/4 of the precession cycle. For example, when a spin excitation field (e.g Hy) is applied, the magnetization begin to spin from -1 to 0 to 1 to 0 to -1, etc. Therefore, to get the magnetization to stop at 1, the applied field needs to be turned-off when the magnetization has crossed the zero point and is in the 0 to I section. The magnetization cannot just stop anywhere, it has only two possibilities, 1 or -1.

In exemplary embodiments of the invention, the first magnetic field is kept constant for a certain time duration (> 0.5 ns) after the second magnetic field is turned-off, or in other words, the magnetic field duration of Hy is always shorter than Hx.

In this exemplary embodiment, the first magnetic field is applied along the horizontal axis and is used to define the final magnetization state of the cell intended for switching. The second magnetic field is referred to as the spin precessional excitation field (along the word line).

### BRIEF DESCRIPTION OF THE DRAWINGS

The above and other aspects of the present invention will become more apparent by describing in detail exemplary embodiments thereof with reference to the attached drawings in which:
FIG. 1 schematically illustrates a multibit device according to an exemplary embodiment of the present invention including two magnetic memory cells (a pair-cell) at one intersection point between the word and bit current lines in the MRAM architecture;
FIG. 2 depicts creating a non-parallel magnetization in the pair cells using shape and/or non-parallel cells alignment;
FIG. 3 illustrates a writing procedure according to an exemplary embodiment of the present invention in which the magnetization of the magnetic element is initially pointed to the right +X direction and external fields are applied to switch the magnetization of the magnetic element to the -X direction;
FIG. 4 illustrates an independent cell addressing procedure of a pair magnetic memory cells;
FIG. 5A schematically shows an initialization of the pair cells in +x direction by first applying (+Hy) + (+Hx) followed by (-Hy) + (+Hx); and FIG. 5B depicts a simulation of the multi-bit MRAM pair-cell using Finite Element Micromagnetic simulation;
FIG. 6 is a schematic drawing showing a four-bit cell structure according to an exemplary embodiment of the present invention;
FIG. 7 schematically illustrates a top and cross-section view of an eight-bit cell according to an exemplary embodiment of the present invention;
Figs. 8 through 28 illustrate methods for manufacturing multi-bit magnetic random access memory device according to an exemplary embodiment of the present invention; and
FIG. 29 illustrates a basic MRAM cell structure with one memory cell located at the intersection between Word and Bit lines.

### DETAILED DESCRIPTION OF EXEMPLARY EMBODIMENTS OF THE PRESENT INVENTION

Hereinafter, exemplary embodiments of the present invention will be described in detail with reference to the accompanying drawings.

Aspects of the present invention, and methods for achieving them will be apparent to those skilled in the art from the detailed description of the exemplary embodiments together with the accompanying drawings. However, the scope of the present invention is not limited to the exemplary embodiments disclosed in the specification, and the present invention can be realized in various types. The described exemplary embodiments are presented only for completely disclosing the present invention and helping those skilled in the art to completely understand the scope of the present invention, and the present invention is defined only by the scope of the claims.

In a first exemplary embodiment of the invention, a multi-bit MRAM is created by a pair of spin-excitation-rield-polarity dependent memory cells. The pair of memory cells (a pair-cell) react differently according to an applied excitation magnetic field polarity.

The first exemplary embodiment includes a memory cell shape which has its effective remnant magnetization direction slightly tilted off the easy-axis or long-axis of the cell element.

The remnant magnetization in the pair-cell is tilted in the opposite direction from the easy axis. This feature allows manipulation of their magnetization independently. Therefore, two bits of information can be stored at one cross-point in the MRAM architecture, accordingly reducing the number of bit and word lines used for the reading and writing processes. As a direct result, a higher magnetic memory density is possible.

Storing two bits of information at one cross-point is possible since writing or changing the magnetization of the free layer of one cell can be accomplished without affecting the information already stored in the other cell

FIG. I schematically shows the first exemplary embodiment of the present invention. The multi-bit MRAM 1 includes magnetic and non-magnetic multilayers.

The multibit MRAM includes two magnetic memory cells 2, 3 (a pair-cell) at one intersection point between the word and bit current lines in the MRAM architecture. In the exemplary embodiments of the invention, the memory cells may share the same orthogonal current line (i.e., the same bit and word lines). Further, the memory cells may have a shared or separate transistor for the sensing operation.

Each of the magnetic memory cells 2, 3, in its most basic form, comprises two ferromagnetic magnetic layers 4, 5, where one the layers 4 acts as a free layer in which magnetization orientation can be altered by an applied external field, while the other magnetic layer 5 serves as a reference layer in which the magnetization direction is fixed or pinned by an antiferromagnetic layer 6 via an exchange bias mechanism. Layer 5 is referred to as the pinned layer.

A non-magnetic spacer layer 7 is accommodated between the ferromagnetic magnetic layers 4, 5. The non-magnetic spacer layer 7 may be either a conductive layer or a nonconductive layer. In the case for a conductive spacer layer, the memory device forms a Giant Magnetoresistance (GMR) structure. On the other hand, a non-conductive layer leads to a MTJ structure.

In either case, the electrical resistance of the multi-bit MRAM according to the invention depends on the relative orientation of magnetization in both the free magnetic layer 4 and the fixed or pinned magnetic layer 5. When the magnetization of these two magnetic layers 4, 5 is in parallel, a low electrical resistant state is generated. Conversely, the resultant resistance is high when the two magnetic layers 4, 5 have an antiparallel alignment. These two states of resistance form the basis of two memories states, 1 and 0.

During a write process, two electrical currents are applied, one along the bit line and the other along the word line. Thus, two orthogonal magnetic fields are generated. The two memory cells can either have a separated CMOS or a shared CMOS for the sensing/writing procedure.

The magnetic layer 4 is the data layer where information is stored, and from which information is read. Magnetization of the layer 4 can be changed via an externally applied magnetic field and/or a spin-polarized electrical current.

Of course, a four-bit cell will have two free magnetic layers 4 per cell. In this case, the free magnetic layers 4 may also have distinct magnetic and physical properties such as saturation magnetization, magnetic anisotropy, layer thickness, magnetostriction coefficient, coercivity, damping constant, and materials, among others.

The magnetically changeable ferromagnetic layers 4 may include the same or differing ferromagnetic material, as well as a same or differing thickness. In exemplary embodiments, the material may comprise an alloy ofNi, Fe, and Co, or a combination thereof. Further, the ferromagnetic material of one memory cell may be different from the other cell, allowing for more efficient spin precession.

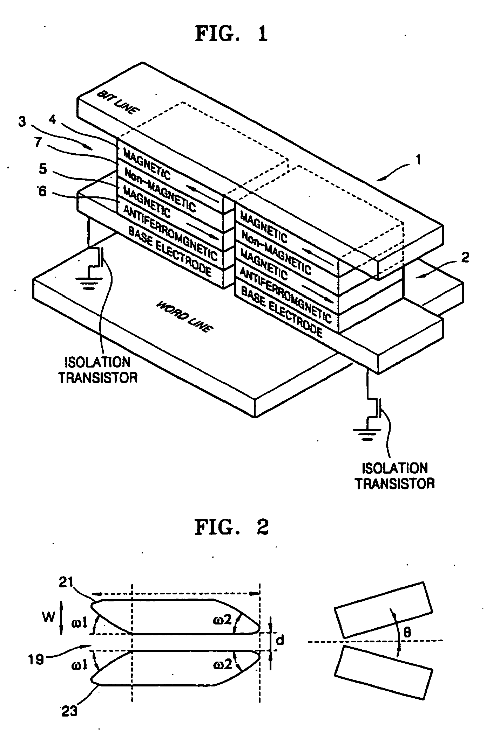

FIG. 2 illustrates the shape of cells of the multi-bit MRAM according to an exemplary embodiment of the invention. In the exemplary embodiment, the multi-bit MRAM is designed such that its effective magnetization is not exactly along the long-axis of the element, but slightly tilted clockwise or counter-clockwise, due to shape magnetic anisotropy.

This tilting is caused by the demagnetizing field created by the cell, which always keep the magnetization orientation parallel to a flat surface. At the edge of the cell, the magnetization orientation keeps its orientation parallel to the surface. As a result, this creates a net or effective magnetization orientation along the cell's diagonal axis.

Accordingly, when a fast orthogonal magnetic field pulse is applied to initiate magnetic spin precession, the precession cone is different between the positive and negative excitation field. Therefore, the magnetization direction in this magnetic element can only be switched by one excitation field polarity but not the opposite below a certain switching field threshold, hence offering selective writing. For example, suppose a magnetic field pulse is applied with a field strength below the threshold value for selective writing. If the Hy is above this threshold value, both magnetic elements will be switched together.

As shown in FIG. 2, a pair-cell 19 includes two memory cells 21, 23 which have the same shape. However, differing cell shapes may also be used among the cells. As shown, the memory cells 21, 23 have a shape such that shorter ends of each cell are at angles that are not perpendicular to the long-axis of the cell (ω₁ and ω₂ ≠ 90°).

In the pair-cell 19 shown, each cell 21, 23 has shorter edges tilted at angles ω₁ and ω₂ in opposing directions from corresponding shorter edges of the other cell. Further, one cell 21 has its shorter edges tilted above a horizontal plane while the other cell 23 has its shorter edges tilted below the horizontal plane.

The tilting angles of the edges ω₁ and ω₂ are less than 90°, respectively, and in exemplary embodiments of the invention, in a range of about 5° to 85°. In addition, these angles ω₁ and ω₂ may be different among the cells. The pointed end of the cells (the edges) may also be slightly rounded, as shown, to allow for suppression of magnetic domain nucleation. Of course, cells with non-rounded or sharp edges will work as well.

Further, in the exemplary embodiment depicted in FIG. 2, although cells 21, 23 have the same shape, they may be fabricated such that their long axis are not in parallel, but form an angle θ with the horizontal axis. In exemplary embodiments, the angle θ is in a range of about 1° to 85°. The cell shapes may include, for example, rectangular and elliptical shapes.

Further still, in another exemplary embodiment, the cells 21, 23 may be configured such that one cell forms an angle θ with the horizontal axis, and the other cell includes a tilting angle ω of an edge. That is, the configurations of the cells may include a combination of features of the aforementioned θ and ω among the cells.

In an exemplary embodiment, the aspect ratio of the cells is between 1.1 and 3.0, and the cells may have the same or differing aspect ratios.

When using pair-cells, it becomes advantageous to sufficiently separate the cells so that the magnetostatic coupling between cells is minimized. In the exemplary embodiment shown in FIG. 2, the separation distance d between cells 21, 23 is 1/2 W, where W represents a width of a cell. In this case, the separation should be greater than ½ W.

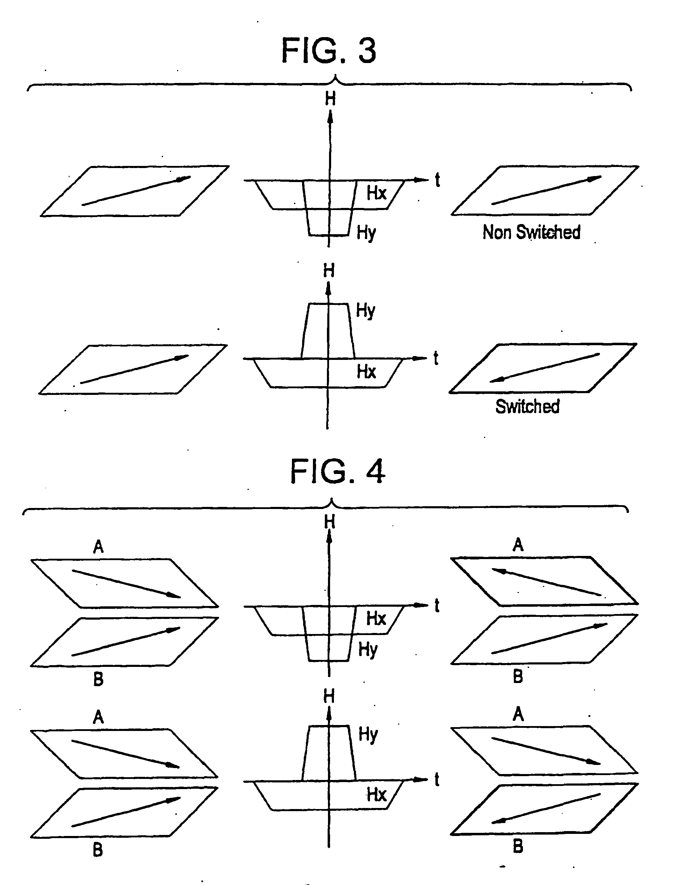

A writing method according to an exemplary embodiment of the invention is explained using FIGs. 3 and 4.

In FIG. 3, the magnetization of a magnetic element is initially pointed to the right +X direction and external fields are applied to switch it to the -x direction. First, a weak -x direction magnetic field is applied which is followed by a stronger and fast -y direction excitation field. However, in this case, due to the smaller precession cone (e.g., where the precession does not crosses zero to the other half of the cycle), the magnetization direction is not changed.

Further, the magnetization of the magnetic element initially pointed in the +x direction may be changed when a y-axis excitation field is applied in the positive direction. Accordingly, selective switching is accommodated.

FIG. 4 depicts an independent cell writing (addressing) procedure of a pair of magnetic memory cells according to an exemplary embodiment of the invention. The memory cells of the pair-cell, labeled as cell A and cell B, initially have their magnetization oriented in the +x direction.

In FIG. 4, when the y-axis excitation field is applied in the negative direction, cell A is switched to the -x direction while leaving cell B unchanged.

Similarly, as shown, if the y-axis excitation field is applied in the positive direction, then cell B will be switched to the negative direction while cell A remains in its original direction. Hence, the magnetic memory cell of the invention may be excitation-field-polarity dependent. Accordingly, this behavior leads to allowing a single-cell selection in the multi-bit cell design of the present invention.

In the writing method of the exemplary embodiment, the second applied magnetic field (the spin-precessional excitation field) may be turned-off as soon as the magnetization of the one cell, for example, cell B, has precessed to more than 1/2 but less than 3/4 of the precession cycle. Subsequently, the first applied magnetic field (the easy axis field) is turned-off after the second applied magnetic field is turned-off. Likewise, the pulse of the easy axis field should have a longer duration than a pulse of the spin-precessional excitation field. In an exemplary embodiment, the pulse duration of the easy axis field is in a range of about 0.2 to 10 ns, while a pulse duration of the spin-precessional excitation field may be in a range of about 0.01 to 5 ns.

The selectivity of writing of the multibit MRAM of the present invention in exemplary embodiments is based on the physics that the effective field generated by Hx and Hy exert a different torque on the magnetic moment of the pairs cells. The torque required to reverse the magnetization direction is maximum when Heff is perpendicular to the magnetization direction and minimum when antiparallel.

In addition, the memory cells of the invention may have the same or differing spin precession frequencies. Also the memory cells may have the same or differing magnetic damping constants to provide for better energy dissipation, as needed.

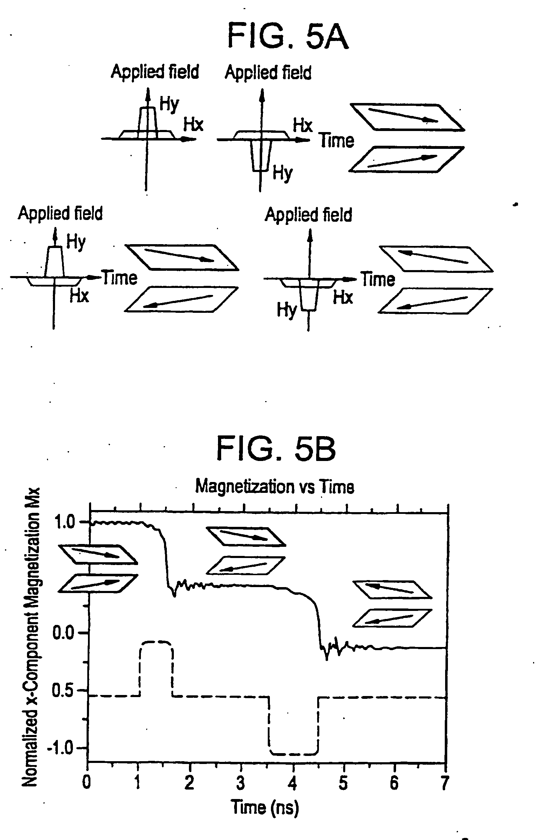

FIG. 5A schematically shows an initialization of the pair cells in +x direction by first applying (+Hy) + (+Hx) followed by (-Hy) + (+Hx).

FIG. 5B depicts a chart created using 3D Finite Element Micromagnetic simulation software to simulate a pair-cell according to an exemplary embodiment of the invention.

As shown in FIG. 5B, a simulation result is obtained for Mx against time. The dotted line shows the timing of Hy. The normalized Mx is zero when both cells are switched because the magnetization of the fixed layer is still in +x. The magnetization in the x, y and z-direction (Mx, My and Mz) may be calculated as a function of time by solving the Landau-Liftshitz-Gilbert equation for the pair of memory cells.

Initially, both cells have positive Mx, thus average unity magnetization. It can be seen that when a positive excitation field is applied (t = 1 ns), that Mx decreases to half. This indicates that the x component of magnetization of the pair cell is in antiparallel alignment, hence half net magnetization.

At t = 3.5 ns, a second negative excitation field is applied. This switches the remaining cell to the -x direction, hence net magnetization is zero. In this case, both memory cells have negative x-component magnetization. In FIG. 5B, the thick, solid line shows the total magnetization evolution with time and the thin dotted line shows the applied Hy.

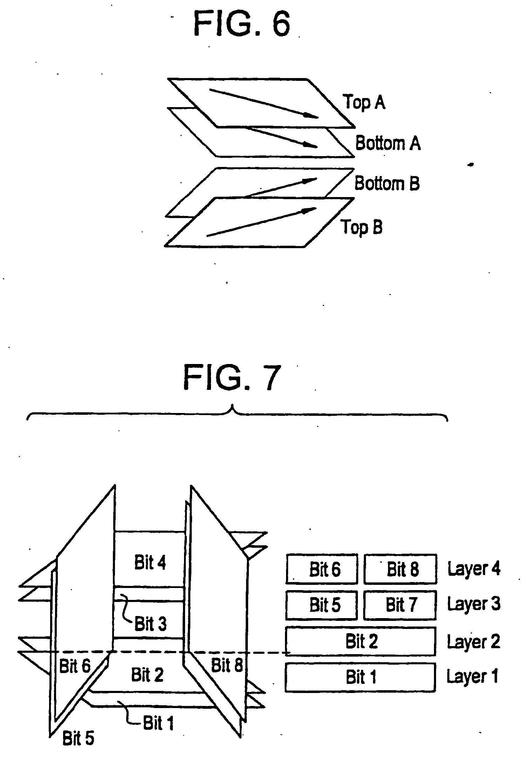

Of course, the present invention is not limited to a two-bit memory structure. For example, a four-bit cell structure is shown in FIG. 6.

The bottom free magnetic layers of this four-bit embodiment are labeled "Bottom A" and "Bottom B" while the top free magnetic layers are labeled "Top A" and "Top B". These four magnetic layers are able to store one bit of binary information each and it is possible to address each bit independently. This may be achieved by using different ferromagnetic material for the bottom and top free layers. This structure gives a total of 8 logic states.

A writing procedure for this four bit structure is similar to the method described above where the magnetic memory cells may be excitation-field-polarity dependent. Table 1 below shows a writing method for each magnetic configuration state using a 4 bit cell which can include sixteen (16) combinations for writing.

In Table 1, Hx_th is the Hx field above the threshold field to switch both layers together, and Hx is below the threshold and can only switch one layer. The Top1 and Bottom1 are written by +Hy and the Top2 and Bottom2 are written by -Hy. Further, the Bottom layer be the magnetically harder layer. Additionally, in the writing method, +Hx writes 1 and -Hx writes 0. In Table I, the contents of the square bracket correspond to [Top1, Bottom1, Top2, Bottom2].

**Table 1**

| | | | | | | | |
|---|---|---|---|---|---|---|---|
| +Hx_th and ±Hy | [1,1,1,1] | -Hx_th and +Hy | [0,0,1,1] | -Hx and - Hy | [0,0,0,1] | +Hx and +Hy | [1,0,0,1] |
| | | | | +Hx and +Hy | [1,0,1,1] | -Hx and - Hy | [1,0,0,1] |
| | | -Hx_th and - Hy | [1,1,0,0] | +Hx and - Hy | [1,1,1,0] | -Hx and +Hy | [0,1,1,0] |
| | | | | -Hx and +Hy | [0,1,0,0] | +Hxand- Hy | [0,1,1,0] |
| | | -Hx and +Hy | [0,1,1,1] | -Hx and - Hy | [0,1,0,1] | | |
| | | -Hx and -Hy | [1,1,0,1] | -Hx and +Hy | [0,1,0,1] | | |
| -Hx_th and +Hy | [0,0,0,0] | +Hx_th and - Hy | [0,0,1,1] | -Hx and - Hy | [0,0,0,1] | +Hx and +Hy | [1,0,0,1] |
| | | | | +Hx and +Hy | [1,0,1,1] | -Hx and - Hy | [1,0,0,1] |
| | | +Hx_th and +Hy | [1,1,0,0] | -Hx and +Hy | [0,1,0,0] | +Hx and - Hy | [0,1,1,0] |
| | | | | +Hx and - Hy | [1,1,1,0] | -Hx and +Hy | [0,1,1,0] |
| | | +Hx and +Hy | [1,0,0,0] | +Hx and - Hy | [1,0,1,0] | | |
| | | +Hx and -Hy | [0,0,1,0] | +Hx and +Hy | [1,0,1,0] | | |

FIG. 7 depicts a top and cross-sectional view showing the design of an eight-bit cell structure according to an exemplary embodiment of the present invention. Using the four-bit cell structure as shown in FIG. 6 as a basic cell, then two 'four-bit cells' are stacked on top of each other. An orthogonal configuration is obtained as an eight-bit structure. In this configuration, the spin precession excitation field for bits 5, 6, 7 and 8 is applied along the x-axis, and along the y-axis for bits 1, 2, 3 and 4. All four ferromagnetic layers may have the same or different ferromagnetic materials.

Multi-bit MRAM of the present invention may be created by growing magnetic multilayers with distinct, saturation magnetization free magnetic layers, where each free layer can store one binary bit information. The memory cell shape can be, for example, rectangular or elliptical. The layers may be formed by film-patterning, doping, etching, and polishing techniques known in the art.

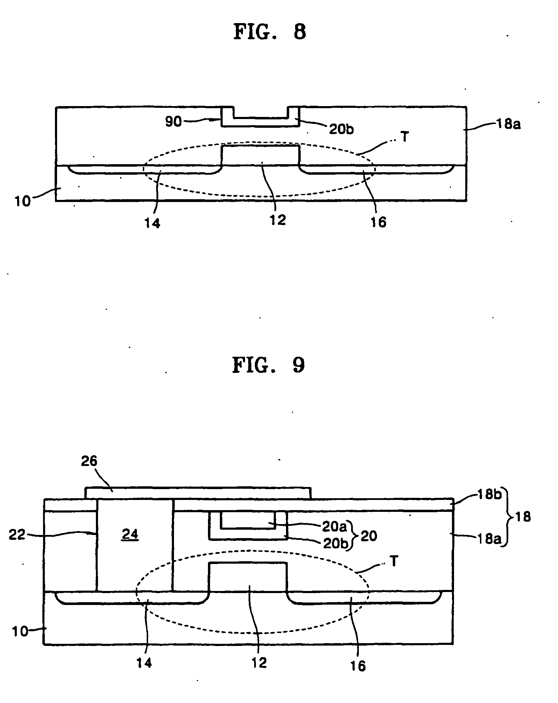

A method of fabricating a magnetic memory device according to an embodiment of the present invention will now be described with reference to FIGS. 8 through 74.

Referring to FIG. 8, a first insulating layer 18a that covers a transistor T is formed on a substrate 10. A groove 90 having a predetermined depth is formed in the first insulating layer 18a. The groove 90 can be formed directly on a gate stack 12. The groove 90 may be formed in a stripe shape parallel to the gate stack 12. Subsequently, a clad layer 20b having a predetermined thickness is formed on an inner wall of the groove 90. The clad layer 20b is a soft magnetic layer for concentrating a magnetic field generated in a conductive layer in a predetermined direction when current flows through the conductive layer filled in the groove 90 in a subsequent process. The clad layer 20b may be formed of NiFe, for example.

Referring to FIG. 9, the groove 90 whose inner wall is covered by the clad layer 20b is filled with a conductive layer 20a. The conductive layer 20a may be a copper layer or an aluminum layer, for example, but may be a different conductive layer. Since the groove 90 has a stripe shape, the conductive layer 20a also has a stripe shape. The conductive layer 20a and the clad layer 20b form a digit line 20. A second insulating layer 18b that covers the digit line 20 is formed on the first insulating layer 18a. The first and second insulating layers 18a and 18b form a first interlayer dielectric (ILD) layer 18. After forming the first ILD layer 18, a contact hole 22 through which a source region 14 is exposed is formed in the first ILD layer 18, and the contact hole 22 is filled with a conductive plug 24. Then, a conductive pad 26 that covers the exposed portion of the conductive plug 24 is formed on the second insulating layer 18b. The conductive pad 26 may cover the digit line 20 sufficiently.

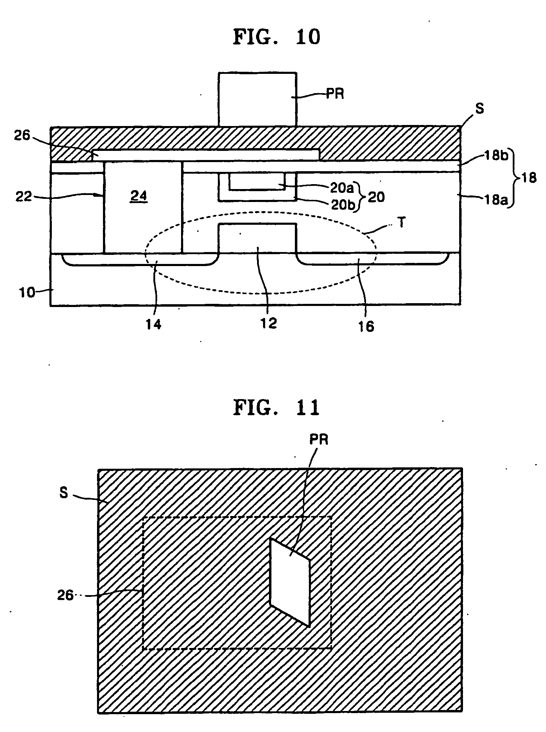

Referring to FIG. 10, a storage medium S that covers the conductive pad 26 is formed on the first ILD layer 18. The storage medium S is formed by sequentially stacking several layers. For example, the storage medium S may be formed by sequentially stacking material layers such as a seed layer, a pinning layer, a pinned layer, a tunneling layer, a free magnetic layer, and a material layer which is used as a capping layer. Also, the storage medium S may have the same form as the cell A or the cell B shown in FIG. 4. Also, the free magnetic layer of the storage medium S may have the same form as the cell A or the cell B shown in FIG. 4. In addition, the storage medium S may include two free magnetic layers. For example, the storage medium S may be formed by sequentially stacking a seed layer, a pinning layer, a first pinned layer, a first spacer (a tunneling layer), a first free magnetic layer, a second spacer (a tunneling layer), a second free magnetic layer, and a material layer which is used as a capping layer. At this time, the first and second free magnetic layers may have the same form as the cell A or the cell B shown in FIG. 4.

Preferably, the material layers used as the free magnetic layer and the first and second free magnetic layers may be magnetic layers in which the spin precession motion of electrons have asymmetry with respect to an external magnetic field pulse applied to their owns. Here, the material layer used as the first free magnetic layer may be a magnetic layer having larger magnetic polarizability than the material used as the second free magnetic layer. Thus, direction of the magnetic polarization of the material layer used as the first free magnetic layer may be more easily inverted with respect to the external magnetic field pulse than in the second free magnetic layer.

The materials used as the first and second free magnetic layers and the materials used as the first and second spacers may be formed to a thickness sufficient to allow the flow of current and to a smaller thickness than a spin diffusion length and an average free path of electrons, for example.

As described above, after forming the storage medium S, a photosensitive layer pattern PR is formed on a predetermined region of the storage medium S. The photosensitive layer pattern PR defines a region in which actual bit data is to be written to the storage medium S.

FIG. 11 is a plan view of the storage medium S and the photosensitive layer pattern PR illustrated in FIG. 10. Referring to FIG. 11, the photosensitive layer pattern PR is a formed in a different geometric shape from a square or a rectangular form, for example, in a parallelogram shape. In an actual process, four edges of the photosensitive layer pattern PR may be not sharp but dull like in the drawing. Since a final resultant structure of the storage medium S may exist on the digit line 20, the photosensitive layer pattern PR may be formed above the digit line 20.

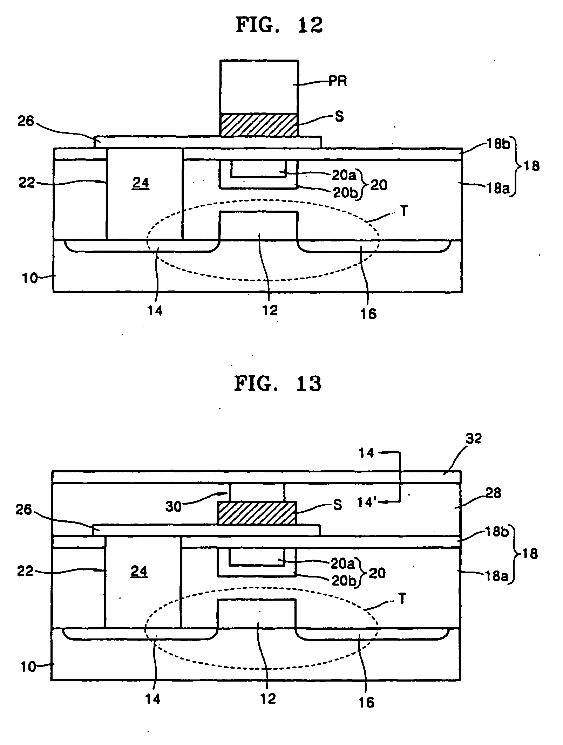

Referring to FIG. 11, the storage medium S is etched until the conductive pad 26 is exposed using the photosensitive layer pattern PR as a mask and the storage medium S is completely removed from the circumference of the photosensitive layer pattern PR. As a result, the storage medium S having a predetermined size where actual bit data is to be written on a predetermined region of the conductive pad 26 corresponding to the digit line 20 is formed, as shown in FIG. 12. After that, the photosensitive layer pattern PR is removed.

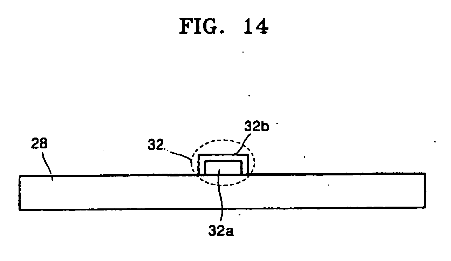

Referring to FIG. 13, a second ILD layer 28 that covers the exposed portion of the conductive pad 26 and the storage medium S is formed on the first ILD layer 18. Subsequently, a via hole 30 through which a top surface of the storage medium S is exposed is formed in the second ILD layer 28. After that, a bit line 32 that fills the via hole 30 is formed on the second ILD layer 28. The bit line 32 may be formed of general metal having high conductivity. However, the bit line 32 may be formed by forming a conductive line 32a having a stripe shape to be orthogonal to the digit line 20 and then sequentially stacking a clad layer 32b that covers the exposed surface of the conductive line 32a, as shown in FIG. 14 which is a cross-sectional view taken along line 14-14' of FIG. 13. At this time, the conductive line 32a and the clad layer 32b may be formed of the same material as the conductive line 20a of the digital line 20 and the clad layer 32b but may be formed of other materials.

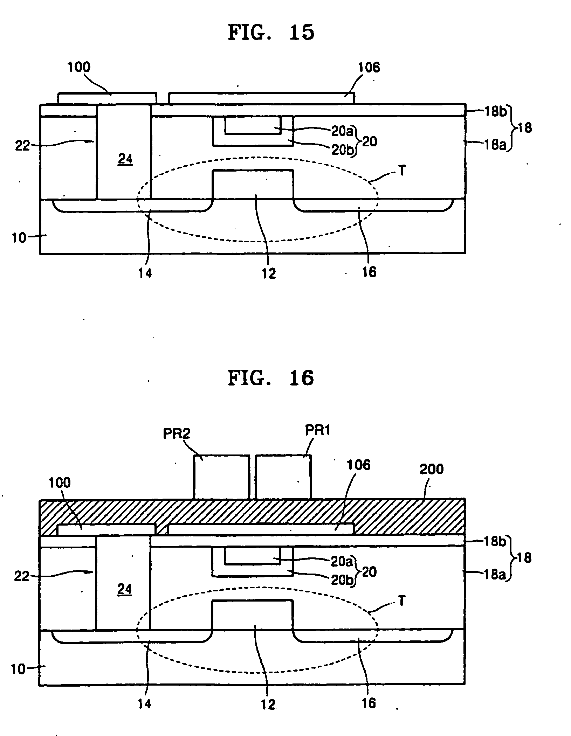

A method of fabricating a magnetic memory device according to another embodiment of the present invention will now be described with reference to FIGS. 15 through 22. A description of the same processes as in the method of fabricating a magnetic memory device shown in FIGS. 8 through 14 will be omitted.

Referring to FIG. 15, a first conductive pad 100 that covers the exposed entire surface of the conductive plug 24 is formed on the first ILD layer 18. Simultaneously, a second conductive pad 106 is formed on a predetermined region of the first ILD layer 18 separated from the first conductive pad 100. The second conductive pad 106 may be placed in a position where it covers the digital line 20. The first and second conductive pads 100 and 106 may be formed of the same material as the conductive plug 24.

Referring to FIG. 16, a storage medium 200 that covers the first and second conductive pads 100 and 106 is formed on the first ILD layer 18. The storage medium 200 may be a material layer having the same structure as the above-described storage medium S. First and second photosensitive layer patterns PR1 and PR2 are formed in a predetermined region of the storage medium 200. The first and second photosensitive layer patterns PR1 and PR2 respectively define a region in which actual bit data is to be written to the storage medium 200. They are formed to be close to each other and not to contact each other. A distance between the first and second photosensitive layer patterns PR1 and PR2 can be adjusted according to resolution limit of an exposure process.

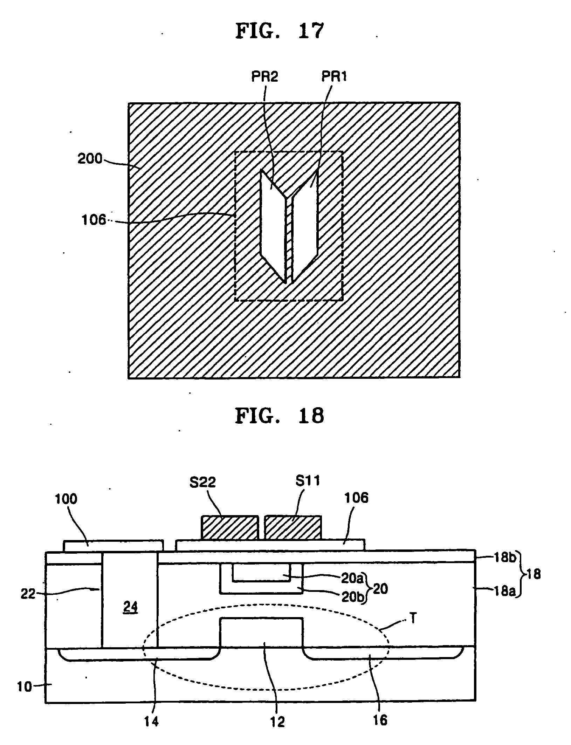

FIG. 17 is a plan view of the storage medium 200 and the photosensitive layer patterns PR1 and PR2 illustrated in FIG. 16. Referring to FIG. 17, the photosensitive layer patterns PR1 and PR2 are formed in a portion of the storage medium 200 that covers the second conductive pad 106. In addition, the first and second photosensitive layer patterns PR1 and PR2 have a different geometric shape from a square or a rectangular form, and for example, in a mirror shape. In a subsequent process, a storage medium which has the same form as the cell A shown in FIG. 4 and may comprise one free magnetic layer or two free magnetic layers may be formed on the second conductive pad 106 using the first photosensitive layer pattern PR1. Also a storage medium which has the same form as the cell B shown in FIG. 4 and may comprise one free magnetic layer or two free magnetic layers may be formed on the second conductive pad 106 using the second photosensitive layer pattern PR2. Next, the storage medium 200 is etched using the first and second photosensitive layer patterns PR1 and PR2 as an etching mask. The etching process is performed until the second conductive pad 106 is exposed. After that, the first and second photosensitive layer patterns PR1 and PR2 are removed. As a result, first and second patterns S11 and S22 of the storage medium 200 are formed on the second conductive pad 106, as shown in FIG. 18.

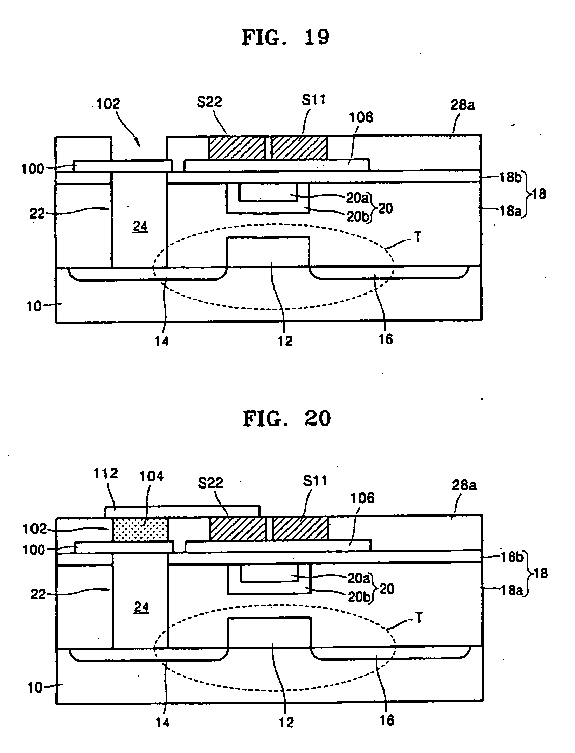

Referring to FIG. 19, a third insulating layer 28a that covers the first and second conductive pads 100 and 106 and the first and second patterns S11 and S22 is formed on the first ILD layer 18. The third insulating layer 28a may be formed of an insulating material that is usually used to fabricate a magnetic memory device. After forming the third insulating layer 28a, a top surface thereof is planarized until the first and second patterns S11 and S22 are exposed. The planarizing of the top surface of the third insulating layer 28a can be performed using chemical mechanical polishing (CMP). After the planarization process, a via hole 102 through which the first conductive pad 100 is exposed is formed in the third insulating layer 28a.

Referring to FIG. 20, the via hole 102 is filled with a conductive plug 104. Subsequently, a conductive line 112 that connects the conductive plug 104 and the second pattern S22 is formed on the third insulating layer 28a. The conductive line 112 may be formed using general deposition and patterning processes.

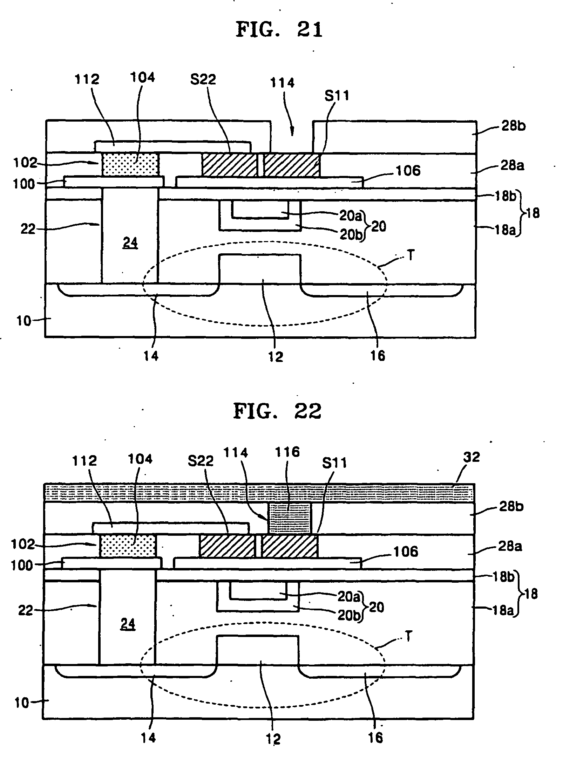

Referring to FIG. 21, a fourth insulating layer 28b that covers the conductive line 112 and the first and second patterns S11 and S22 is formed on the third insulating layer 28a. The third and fourth insulating layers 28a and 28b form the second ILD layer 28. After forming the fourth insulating layer 28b, a via hole 114 through which a top surface of the first pattern S11 is exposed is formed in the fourth insulating layer 28b.

Referring to FIG. 22, the via hole 114 is filled with a conductive plug 116 and then, a bit line 32 that contacts the conductive plug 116 is formed on the fourth insulating layer 28b.

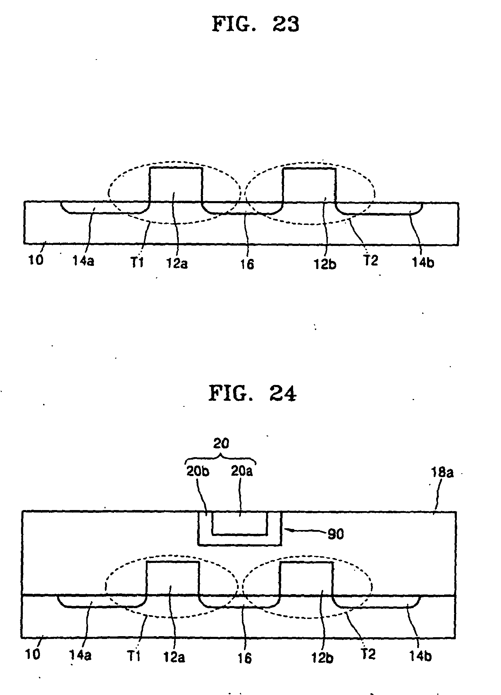

A method of fabricating a magnetic memory device according to another embodiment of the present invention will now be described with reference to FIGS. 23 through 28.

Referring to FIG. 23, first and second stacks 12a and 12b, which are separated from each other by a predetermined gap, are formed on a substrate 10. The first and second gate stacks 12a and 12b may include a gate insulating layer, a gate electrode, a gate-side spacer, and an upper passivation layer. Conductive impurities are doped onto the substrate 10 to a predetermined depth using the first and second gate stacks 12a and 12b as a mask, and an annealing process for diffusion of the conductive impurities is performed. The conductive impurities may be n-type or p-type impurities. A first source region 14a is formed on the right of the first gate stack 12a of the substrate 10, a common drain region 16 is formed on the left of the first gate stack 12a of the substrate 10, and a second source region 14b is formed on the left of the second gate stack 12b. In this way, a first transistor T1 including the first source region 14a, the first gate stack 12a, and the common drain region 16, and a second transistor T2 including the second source region 14b, the second gate stack 12b, and the common drain region 16 are respectively formed.

Referring to FIG. 24, a first insulating layer 18a that covers the first and second transistors T1 and T2 is formed on the substrate 10. A groove 90 having a predetermined depth is formed in the first insulating layer 18a. Thus, the groove 90 may be formed between the first and second gate stacks 12a and 12b. After forming the groove 90, a clad layer 20b made of a soft magnetic material having a predetermined thickness is formed inside the groove 90. The groove 90 whose inside is covered by the clad layer 20b is filled with the conductive material 20b. Since the groove 90 has a line shape, the conductive material 20b is a conductive line when viewing from the upper portion of the drawing. The clad layer 20b and the conductive material 20b form a digit line 20 that generates a magnetic field pulse in a hard axial direction.

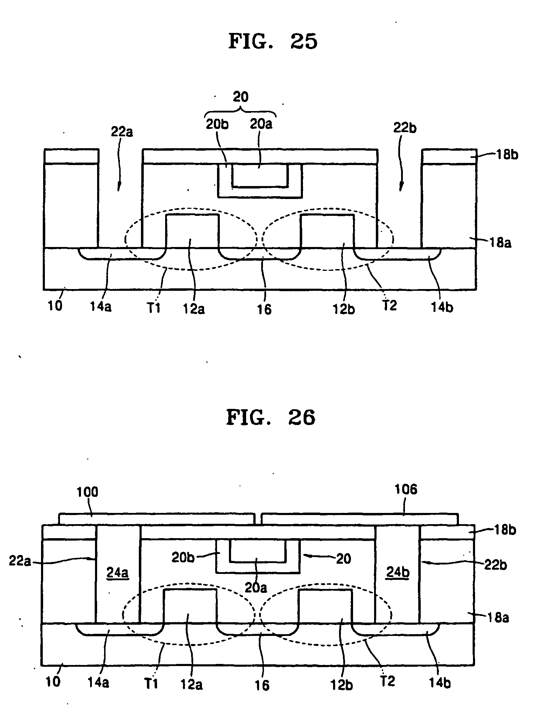

Referring to FIG. 25a second insulating layer 18b that covers the digit line 20 is formed on the first insulating layer 18a. A first contact hole 22a through which the first source region 14a is exposed, and a second contact hole 22b through which the second source region 14b is exposed are respectively formed in the first ILD layer 18 comprised of the first and second insulating layers 18a and 18b.

Referring to FIG. 26, the first and second contact holes 22a and 22b are filled with the first and second conductive plugs 24a and 24b. Subsequently, a first conductive pad 100 that covers the top surface of the first conductive plug 24a and extends on the digit line 20, and a second conductive pad 106 that covers the top surface of the second conductive plug 24b and extends on the digit line 20 are formed on the first ILD layer 18. The first and second conductive pads 100 and 106 are separated from each other on the digital line 20.

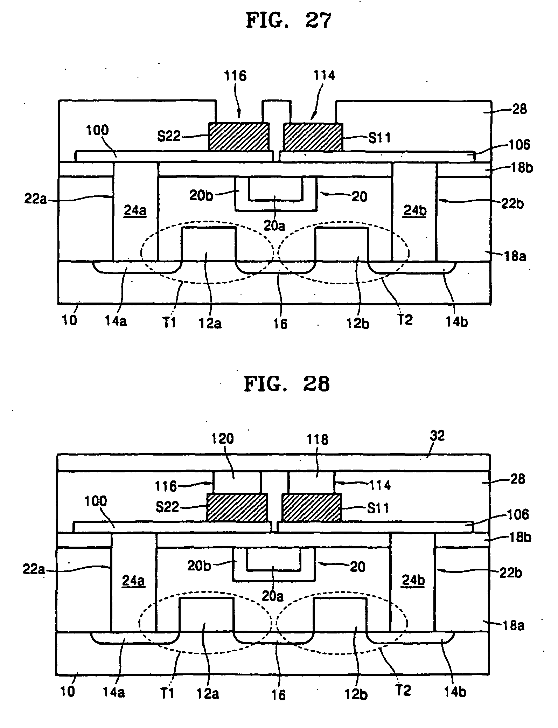

Referring to FIG. 27, first and second storage mediums S11 and S22 are formed on the first and second conductive pads 100 and 106, respectively. The first and second storage mediums S11 and S22 can be formed using the same process as the process of forming the first and second patterns S11 and S22 of FIG. 15. The first and second storage mediums S11 and S22 are separated from each other by a predetermined distance. A second ILD layer 28 that covers the first and second conductive pads 100 and 106 and the first and second storage mediums S11 and S22 is formed on the first ILD layer 18. Subsequently, a first via hole 114 through which the top surface of the first storage medium S11 is exposed, and a second via hole 116 through which the top surface of the second storage medium S22 are respectively formed in the second ILD layer 28.

Referring to FIG. 28, the first and second via holes 114 and 116 are respectively filled with third and fourth conductive plugs 118 and 120, and then, a bit line 32 that contacts the third and fourth conductive plugs 118 and 120 and generates a magnetic field pulse in an easy axial direction is formed on the second ILD layer 28. The bit line 32 may be orthogonal to the digit line 20.

The difference in saturation magnetization allows recording information in one bit without affecting the information in the other bit. This allows for selective writing, and is made possible because the two magnetic free layers have different spin precession cone angles.

Accordingly, the present invention allows for improved data density by using a multi-bit MRAM structure, where the memory cells are arranged such that an effective remnant magnetization of each of the cells is non-parallel from the cells' long axis.

Further, the present invention may use spin precessional switching which is energy efficient.

In addition, high frequency cell writing is possible, therefore leading to a higher data transfer rate.

Finally, the present invention allows for reducing the number of bit and word lines in the current MRAM architecture for a multi-bit MRAM.

Although exemplary embodiments of the present invention have been described for illustrative purposes, those skilled in the art will appreciate that various modifications, additions and substitutions are possible, without departing from the scope of the invention as disclosed in the accompanying claims.

## Claims

1. A magnetic memory comprising:
intersecting word and bit lines (1, 2, 20, 32);
at least one pair-cell (2, 3), each pair-cell (4) comprising first (2) and second (3) memory cells at a single intersection of the word and bit lines (1, 2, 20, 32) and the first and second memory cells each having a magnetic multilayer structure, the structure comprising a stack of:
a magnetically changeable ferromagnetic layer (4);
a ferromagnetic reference layer (5) having a non-changeable magnetization state; and
a corresponding spacer layer (7) separating the magnetically changeable and non-changeable ferromagnetic layers;
**characterised in that** the first and second memory cells are arranged such that an effective remnant magnetization of each of the cells is non-parallel from the long-axis of the cells;
wherein each memory cell (2, 3) has shorter edges tilted at a tilting angle ω to the long axis of the cell and with the long axis at an angle θ to the plane of the word and bit lines;
each memory cell (2, 3) has tilting angles ω in the range 5° to 85° and has shorter edges tilted in opposite directions; and/or
each memory cell (2,3) has a long axis at an angle in the range 1° to 85° and is tilted in opposite directions; or
one memory cell (2, 3) has a tilting angle ω in the range 5° to 85° and the other cell has an angle in the range 1° to 85°.

2. The magnetic memory according to claim 1, wherein the spacer layer(7) is non-conductive.

3. The magnetic memory according to claim 1, wherein the spacer layer (7) is conductive.

4. The magnetic memory according to claim 1, wherein the magnetically changeable ferromagnetic layer (4) of the first memory cell (2) of the pair-cell has a different ferromagnetic material as the magnetically changeable ferromagnetic layer of the second memory cell (3) of the pair-cell.

5. The magnetic memory according to claim 1, wherein the magnetically changeable ferromagnetic layer (4) of the first memory cell (2) of the pair-cell has a differing thickness as a thickness of the magnetically changeable ferromagnetic layer of the second memory cell (3) of the pair-cell.

6. The magnetic memory according to claim 1, wherein the magnetically changeable ferromagnetic layer (4) of the first memory cell (2) of the pair-cell has a differing saturation magnetic moment as the magnetically changeable ferromagnetic layer of the second memory cell (3) of the pair-cell.

7. The magnetic memory according to claim 1, wherein the magnetically changeable ferromagnetic layer (4) of the first memory cell (2) of the pair-cell has a differing magnetocrystalline anisotropy as the magnetically changeable ferromagnetic layer of the second memory cell (3) of the pair-cell.

8. The magnetic memory according to claim 1, wherein the first and second memory cells (2, 3) of the pair-cell have a differing cell shape.

9. The magnetic memory according to claim 1, wherein the first (2) and second (3) memory cells have a quadrilateral shape, and a length of each memory cell (2, 3) is larger than a width of the memory cell.

10. The magnetic memory according to claim 9, wherein shorter ends of each of the first and second memory cells (2, 3) are angled away from the long axis of the memory cell, at angles less than 90°.

11. The magnetic memory according to claim 10, wherein the angles are in a range of about 5° to 85°.

12. The magnetic memory according to claim 9, wherein the first memory cell (2) of the pair-cell has its shorter ends angled in a direction above a horizontal plane, while the second memory cell (3) has its shorter ends angled in an opposing direction below the horizontal plane.

13. The magnetic memory according to claim 9, wherein an intersection of a long side with a short side in at least one of the first and second memory cells (2, 3) is rounded to suppress magnetic domain nucleation.

14. The magnetic memory according to claim 9, wherein the long axis of each of the first and second memory cells (2, 3) is angled away from a horizontal plane.

15. The magnetic memory according to claim 14, wherein the long axis of the first memory cell (2) of the pair-cell is angled above the horizontal plane, while the long axis of the second memory cell (3) is angled in a direction opposite to the long axis of the first memory cell, below the horizontal plane.

16. The magnetic memory according to claim 15, wherein the long axis of the first memory cell (2) is at an angle in a range of about 1° to 85°, while the long axis of the second memory cell (3) is at an angle in a range of about
-1° to -85°.

17. The magnetic memory according to claim 9, wherein the first memory cell (2) of the pair-cell has its shorter ends angled in a direction above a horizontal plane, while the long axis of the second memory cell (3) is angled below the horizontal plane.

18. The magnetic memory according to claim 9, wherein the first memory cell (2) of the pair-cell has its shorter ends angled in a direction below a horizontal plane, while the long axis of the second memory cell (3) is angled above the horizontal plane.

19. The magnetic memory according to claim 1, wherein the first and second memory cells (2, 3) are separated at a distance of at least half the width of a cell to minimize magnetostatic coupling between the cells.

20. The magnetic memory according to claim 1, wherein the first and second memory cells (2, 3) of the pair-cell share a same orthogonal current line.

21. The magnetic memory according to claim 1, wherein the first and second memory cells (2, 3) of the pair-cell have a shared transistor for sensing operation.

22. The magnetic memory according to claim 1, wherein an aspect ratio of each cell (2, 3) is between 1.1 and 5.0.

23. The magnetic memory according to claim 22, wherein the first and second memory cells (2, 3) of the pair-cell have a differing aspect ratio.

24. The magnetic memory according to claim 1, wherein the magnetically changeable ferromagnetic layer (4) comprises an alloy of Ni, Fe and Co, or a combination thereof.

25. The magnetic memory according to claim 1, wherein the first and second memory cells (2, 3) each have a plurality of magnetically changeable ferromagnetic layers, one of the magnetically changeable ferromagnetic layers at a bottom of the structure, and another at a top of the structure.

26. The magnetic memory according to claim 25, wherein each magnetically changeable ferromagnetic layer stores one bit of binary information.

27. The magnetic memory according to claim 25, comprising two pair-cells, wherein each pair-cell stores two bits of binary information.

28. The magnetic memory according to claim 27, comprising four pair-cells, with two pair cells stacked on top of each other in an orthogonal configuration, forming an eight bit cell structure.

29. The magnetic memory according to claim 28, wherein a spin precession excitation field axis for a bottom four bits is perpendicular to a top four bits, such that when the bottom four bits cell are excited to precession, the top four bits are not excited to precession.

30. The magnetic memory according to claim 28, wherein a spin precession excitation field axis for a bottom four bits is perpendicular to a top four bits, such that when the top four bits cell are excited to precession, the bottom four bits are not excited to precession.

31. The magnetic memory according to claim 1, wherein the first and second memory cells (2, 3) of the pair-cell have a differing spin precession frequency.

32. The magnetic memory according to claim 1, wherein the first and second memory cells (2, 3) of the pair-cell have a differing magnetic damping constant to allow for magnetic energy dissipation.

33. A writing method for a magnetic memory comprising at least one pair-cell which comprises first and second memory cells (2, 3) arranged at the intersection of a single intersection of a word line (2) and a bit line (1) wherein each memory cell (2, 3) has shorter edges tilted at a tilting angle ω to the long axis of the cell and with the long axis at an angle to the plane of the word and bit lines;
each memory cell (2, 3) has tilting angles ω in the range 5° to 85° and has shorter edges tilted in opposite directions; and/or
each memory cell (2, 3) has a long axis at an angle in the range 1° to 85° and is tilted in opposite directions; or
one memory cell (2, 3) has a tilting angle ω in the range 5° to 85° and the other cell has an angle θ in the range 1° to 85°; the method comprising:
applying a first magnetic field below a switching field of the pair-cell along a long axis of the first and second memory cells (2, 3);
applying a second magnetic field orthogonal to the first magnetic field, the second magnetic field having a strength sufficient to create a spin precession angle large enough to switch magnetization of the first memory cell (2) of the pair-cell to an opposite direction but not enough strength to switch the magnetization of second memory cell (3) of the pair-cell,
wherein the second magnetic field is turned-off as soon as the magnetization of the first cell (2) has precessed to more than about 1/2 but less than about 3/4 of the precession cycle.

34. The writing method for a magnetic memory according to claim 33, wherein the first magnetic field is turned-off after the second magnetic field is turned-off.

35. The writing method for a magnetic memory according to claim 33, wherein a pulse of the first magnetic field has a longer duration than a pulse of the second magnetic field.

36. The writing method for a magnetic memory according to claim 33, wherein a pulse of the second magnetic field has a rise time of equal to or less than 1 ns.

37. The writing method for a magnetic memory according to claim 33, wherein one of the first and second memory cells is selected for writing by changing the polarity of the second magnetic field.

38. The writing method for a magnetic memory according to claim 36, wherein the pulse of the second magnetic field is of a shape that generates a fast rising field.

39. The writing method for a magnetic memory according to claim 38, wherein the shape is one of trapezoidal or exponential.

40. The writing method for a magnetic memory according to claim 33, further comprising sensing stored information in each cell using a magnetoresistance effect.

41. The writing method for a magnetic memory according to claim 33, further comprising terminating the second magnetic field when the magnetization of the first memory cell has been through (n + 1/2) precession cycles, where n is the number of precession cycles.

42. The writing method for a magnetic memory according to claim 33, wherein magnetization of the first and second memory cells is switched by applying an external magnetic field, utilizing a spin polarized current, or a combination thereof.

43. The writing method for a magnetic memory according to claim 33, wherein a pulse strength of the first magnetic field is a same or differing when switching each individual bit in the pair-cell.

44. The writing method according to claim 33, wherein a pulse duration of the first magnetic field is in a range of about 0.2 to 10 ns while a pulse duration of the second magnetic field is in a range of about 0.01 to 5 ns.

## Patentansprüche

1. Magnetspeicher umfassend:
einander schneidende Wort- und Bitleitungen (1, 2, 20, 32);
mindestens eine Paarzelle (2, 3), wobei jeder Paarzelle (4) eine erste (2) und eine zweite (3) Speicherzelle an einem einzigen Schnittpunkt der Wort- und Bitleitungen (1, 2, 20, 32) umfasst und die erste und zweite Speicherzelle jeweils eine magnetische Mehrschichtstruktur aufweisen, wobei die Struktur einen Stapel umfasst mit:
einer magnetisch veränderbaren ferromagnetischen Schicht (4);
einer ferromagnetischen Referenzschicht (5) mit einem unveränderbaren Magnetisierungszustand; und
einer entsprechenden Abstandhalterschicht (7), die die magnetisch veränderbare und die unveränderbare ferromagnetische Schicht trennt;
**dadurch gekennzeichnet, dass** die erste und zweite Speicherzelle derart ausgebildet sind, dass eine effektive Restmagnetisierung jeder der Zellen nichtparallel zur langen Achse der Zellen ist;
wobei jede Speicherzelle (2, 3) kürzere Kanten aufweist, die in einem Neigungswinkel w zur langen Achse der Zelle geneigt sind, und wobei die lange Achse in einem Winkel θ zur Ebene der Wort- und Bitleitungen liegt;
jede Speicherzelle (2, 3) Neigungswinkel w im Bereich von 5° bis 85° aufweist und kürzere Kanten aufweist, die in entgegengesetzten Richtungen geneigt sind; und/oder
jede Speicherzelle (2, 3) eine lange Achse in einem Winkel θ im Bereich von 1 ° bis 85° aufweist und in entgegengesetzte Richtung geneigt ist; oder
eine Speicherzelle (2, 3) einen Neigungswinkel w im Bereich von 5° bis 85° aufweist und die andere Zelle einen Winkel θ im Bereich von 1 ° bis 85° aufweist.

2. Magnetspeicher nach Anspruch 1, wobei die Abstandhalterschicht (7) nicht leitfähig ist.

3. Magnetspeicher nach Anspruch 1, wobei die Abstandhalterschicht (7) leitfähig ist.

4. Magnetspeicher nach Anspruch 1, wobei die magnetisch veränderbare ferromagnetische Schicht (4) der ersten Speicherzelle (2) der Paarzelle ein anderes ferromagnetisches Material aufweist als die magnetisch veränderbare ferromagnetische Schicht der zweiten Speicherzelle (3) der Paarzelle.

5. Magnetspeicher nach Anspruch 1, wobei die magnetisch veränderbare ferromagnetische Schicht (4) der ersten Speicherzelle (2) der Paarzelle eine andere Dicke aufweist als die Dicke der magnetisch veränderbaren ferromagnetischen Schicht der zweiten Speicherzelle (3) der Paarzelle.

6. Magnetspeicher nach Anspruch 1, wobei die magnetisch veränderbare ferromagnetische Schicht (4) der ersten Speicherzelle (2) der Paarzelle ein anderes magnetisches Sättigungsmoment aufweist als die magnetisch veränderbare ferromagnetische Schicht der zweiten Speicherzelle (3) der Paarzelle.

7. Magnetspeicher nach Anspruch 1, wobei die magnetisch veränderbare ferromagnetische Schicht (4) der ersten Speicherzelle (2) der Paarzelle eine andere magnetokristalline Anisotropie aufweist als die magnetisch veränderbare ferromagnetische Schicht der zweiten Speicherzelle (3) der Paarzelle.

8. Magnetspeicher nach Anspruch 1, wobei die erste und zweite Speicherzelle (2, 3) der Paarzelle eine unterschiedliche Zellenform aufweisen.

9. Magnetspeicher nach Anspruch 1, wobei die erste (2) und zweite (3) Speicherzelle eine vierseitige Form aufweisen und eine Länge jeder Speicherzelle (2, 3) größer ist als eine Breite der Speicherzelle.

10. Magnetspeicher nach Anspruch 9, wobei kürzere Enden der ersten und zweiten Speicherzelle (2, 3) in Winkeln von weniger als 90° zu der langen Achse der Speicherachse schräg stehen.

11. Magnetspeicher nach Anspruch 10, wobei die Winkel in einem Bereich von ungefähr 5° bis 85° liegen.

12. Magnetspeicher nach Anspruch 9, wobei in der ersten Speicherzelle (2) der Paarzelle die kürzeren Enden in eine Richtung über einer horizontalen Ebene gewinkelt sind, während in der zweiten Speicherzelle (3) die kürzeren Enden in einer entgegengesetzten Richtung unter der horizontale Ebene gewinkelt sind.

13. Magnetspeicher nach Anspruch 9, wobei ein Schnittpunkt einer langen Seite mit einer kurzen Seite in der ersten und/oder zweiten Speicherzelle (2, 3) abgerundet ist, um eine magnetische Domänennukleation zu unterdrücken.

14. Magnetspeicher nach Anspruch 9, wobei die lange Achse der ersten und zweiten Speicherzelle (2,3) unter einem Winkel zu einer horizontalen Ebene steht.

15. Magnetspeicher nach Anspruch 14, wobei die lange Achse der ersten Speicherzelle (2) der Paarzelle über der horizontalen Ebene gewinkelt ist, während die lange Achse der zweiten Speicherzelle (3) in einer Richtung entgegengesetzt zur langen Achse der ersten Speicherzelle unter der horizontalen Ebene gewinkelt ist.

16. Magnetspeicher nach Anspruch 15, wobei die lange Achse der ersten Speicherzelle (2) in einem Winkel in einem Bereich von ungefähr 1 ° bis 85° liegt, während die lange Achse der zweiten Speicherzelle (3) in einem Winkel in einem Bereich von ungefähr -1 ° bis -85° liegt.

17. Magnetspeicher nach Anspruch 9, wobei in der ersten Speicherzelle (2) der Paarzelle die kürzeren Enden in eine Richtung über eine horizontale Ebene gewinkelt sind, während die lange Achse der zweiten Speicherzelle (3) unter die horizontale Ebene gewinkelt ist.

18. Magnetspeicher nach Anspruch 9, wobei in der ersten Speicherzelle (2) der Paarzelle die kürzeren Enden in eine Richtung unter eine horizontale Ebene gewinkelt sind, während die lange Achse der zweiten Speicherzelle (3) über die horizontale Ebene gewinkelt ist.

19. Magnetspeicher nach Anspruch 1, wobei die erste und zweite Speicherzelle (2, 3) in einem Abstand von mindestens der Hälfte der Breite einer Zelle getrennt sind, um magnetostatische Kopplung zwischen den Zellen zu minimieren.

20. Magnetspeicher nach Anspruch 1, wobei die erste und zweite Speicherzelle (2, 3) der Paarzelle dieselbe orthogonale Stromleitung verwenden.

21. Magnetspeicher nach Anspruch 1, wobei die erste und zweite Speicherzelle (2, 3) der Paarzelle einen gemeinsamen Transistor für Abtastbetrieb besitzen.

22. Magnetspeicher nach Anspruch 1, wobei jede Zelle (2, 3) ein Seitenverhältnis zwischen 1,1 und 5,0 aufweist.

23. Magnetspeicher nach Anspruch 22, wobei die erste und zweite Speicherzelle (2, 3) der Paarzelle ein unterschiedliches Seitenverhältnis aufweisen.

24. Magnetspeicher nach Anspruch 1, wobei die magnetisch veränderbare ferromagnetische Schicht (4) eine Legierung aus Ni, Fe und Co, oder eine Kombination davon umfasst.

25. Magnetspeicher nach Anspruch 1, wobei die erste und zweite Speicherzelle (2, 3) jeweils eine Mehrzahl von magnetisch veränderbaren ferromagnetischen Schichten aufweisen, eine der magnetisch veränderbaren ferromagnetischen Schichten an einer Unterseite der Struktur und eine andere an einer Oberseite der Struktur.

26. Magnetspeicher nach Anspruch 25, wobei jede magnetisch veränderbare ferromagnetische Schicht ein Bit binäre Information speichert.

27. Magnetspeicher nach Anspruch 25, umfassend zwei Paarzellen, wobei jede Paarzelle zwei Bits binäre Information speichert.

28. Magnetspeicher nach Anspruch 27, umfassend vier Paarzellen, wobei zwei Paarzellen in einer orthogonalen Konfiguration übereinander gestapelt sind, so dass eine Zellenstruktur für acht Bits gebildet ist.

29. Magnetspeicher nach Anspruch 28, wobei eine Spinpräzessionsanregungsfeldachse für untere vier Bits senkrecht zu oberen vier Bits ist, so dass die oberen vier Bits nicht zur Präzession angeregt werden, wenn die untere Vierbit-Zelle zur Präzession angeregt wird,.

30. Magnetspeicher nach Anspruch 28, wobei eine Spinpräzessionsanregungsfeldachse für untere vier Bits senkrecht zu oberen vier Bits ist, so dass die unteren vier Bits nicht zur Präzession angeregt werden, wenn die obere Vierbit-Zelle zur Präzession angeregt wird.

31. Magnetspeicher nach Anspruch 1, wobei die erste und zweite Speicherzelle (2, 3) der Paarzelle eine unterschiedliche Spinpräzessionsfreqeunz aufweisen.

32. Magnetspeicher nach Anspruch 1, wobei die erste und zweite Speicherzelle (2, 3) der Paarzelle eine unterschiedliche Magnetdämpfungskonstante aufweisen, so dass Magnetenergiedissipation möglich ist.

33. Schreibverfahren für einen Magnetspeicher umfassend mindestens eine Paarzelle, das eine erste und eine zweite Speicherzelle (2, 3) umfasst, die am Schnittpunkt eines einzigen Schnittpunkts einer Wortleitung (2) und einer Bitleitung (1) angeordnet ist, wobei in jeder Speicherzelle (2, 3) kürzere Kanten in einem Neigungswinkel w zur langen Achse der Zelle geneigt sind und wobei die lange Achse in einem Winkel θ zur Ebene der Wort- und Bitleitungen liegt;
jede Speicherzelle (2, 3) Neigungswinkel w im Bereich von 5° bis 85° aufweist und kürzere Kanten aufweist, die in entgegengesetzten Richtungen geneigt sind; und/oder
jede Speicherzelle (2, 3) eine lange Achse in einem Winkel θ im Bereich von 1 ° bis 85° aufweist und in entgegengesetzte Richtung geneigt ist; oder
eine Speicherzelle (2, 3) einen Neigungswinkel w im Bereich von 5° bis 85° aufweist und die andere Zelle einen Winkel θ im Bereich von 1° bis 85° aufweist, wobei das Verfahren umfasst:
Anlegen eines ersten Magnetfelds unter einem Schaltfeld der Paarzelle entlang einer langen Achse der ersten und zweiten Speicherzelle (2, 3);
Anlegen eines zweiten Magnetfelds orthogonal zum ersten Magnetfeld, wobei das zweite Magnetfeld eine ausreichende Stärke aufweist, dass ein Spinpräzessionswinkel ausgebildet wird, der groß genug ist, dass die Magnetisierung der ersten Speicherzelle (2) der Paarzelle in eine entgegengesetzte Richtung umgeschaltet wird, aber nicht stark genug ist, dass die Magnetisierung der zweiten Speicherzelle (3) der Paarzelle umgeschaltet wird;
wobei das zweite Magnetfeld abgeschaltet wird, sobald die Magnetisierung der ersten Zelle (2) um mehr als 1/2, aber weniger als ungefähr 3/4 des Präzessionszyklus präzediert hat.

34. Schreibverfahren für einen Magnetspeicher nach Anspruch 33, wobei das erste Magnetfeld abgeschaltet wird, nachdem das zweite Magnetfeld abgeschaltet ist.

35. Schreibverfahren für einen Magnetspeicher nach Anspruch 33, wobei ein Puls des ersten Magnetfelds eine längere Dauer aufweist als ein Puls des zweiten Magnetfelds.

36. Schreibverfahren für einen Magnetspeicher nach Anspruch 33, wobei ein Puls des zweiten Magnetfelds eine Anstiegsdauer gleich oder kleiner als 1 ns aufweist.

37. Schreibverfahren für einen Magnetspeicher nach Anspruch 33, wobei eine der ersten und zweiten Speicherzelle durch Verändern der Polarität des zweiten Magnetfelds zum Einschreiben ausgewählt wird.

38. Schreibverfahren für einen Magnetspeicher nach Anspruch 36, wobei der Puls des zweiten Magnetfelds eine Form aufweist, die ein schnell ansteigendes Feld erzeugt.

39. Schreibverfahren für einen Magnetspeicher nach Anspruch 38, wobei die Form trapezförmig oder exponential ist.

40. Schreibverfahren für einen Magnetspeicher nach Anspruch 33, ferner umfassend Abtasten gespeicherter Information in jeder Zelle unter Verwendung eines Magnetwiderstandseffekts.

41. Schreibverfahren für einen Magnetspeicher nach Anspruch 33, ferner umfassend Beenden des zweiten Magnetfelds, wenn die Magnetisierung der ersten Speicherzelle (n + 1/2) Präzessionszyklen durchlaufen hat, wobei n die Anzahl der Präzessionszyklen ist.

42. Schreibverfahren für einen Magnetspeicher nach Anspruch 33, wobei die Magnetisierung der ersten und zweiten Speicherzelle durch Anlegen eines externen Magnetfelds, Verwenden eines spinpolarisierten Stroms oder einer Kombination davon umgeschaltet wird.

43. Schreibverfahren für einen Magnetspeicher nach Anspruch 33, wobei eine Pulsstärke des ersten Magnetfelds gleich oder unterschiedlich ist, wenn jedes einzelne Bit in der Paarzelle umgeschaltet wird.

44. Schreibverfahren nach Anspruch 33, wobei eine Pulsdauer des ersten Magnetfelds in einem Bereich von ungefähr 0,2 bis 10 ns liegt, während eine Pulsdauer des zweiten Magnetfelds in einem Bereich von ungefähr 0,01 bis 5 ns liegt.

## Revendications

1. Mémoire magnétique comprenant :
■ des lignes de mot et de bit intersectées (1, 2, 20, 32) ;
■ au moins une cellule-paire (2, 3), chaque cellule-paire (4) comprenant des première (2) et deuxième (3) cellules de mémoire au niveau d'une unique intersection de lignes de mot et de bit (1, 2, 20, 32) et les première et deuxième cellules de mémoire ayant une structure multicouche magnétique, la structure comprenant un empilement de :
■ une couche ferromagnétique modifiable magnétiquement (4) ;
■ une couche de référence ferromagnétique (5) ayant un état de magnétisation non modifiable ; et
■ une couche intercalaire correspondante (7) séparant les couches ferromagnétiques magnétiquement modifiable et non modifiable ;
**caractérisé en ce que** les première et deuxième cellules de mémoire sont agencées de manière qu'une magnétisation rémanente effective de chacune des cellules soit non parallèle par rapport à l'axe long des cellules ;
dans laquelle chaque cellule de mémoire (2, 3) a des bords courts inclinés avec un angle d*'*inclinaison ω par rapport à l'axe long de la cellule et avec l'axe long à un angle θ par rapport au plan des lignes de mot et de bit ;
chaque cellule de mémoire (2, 3) a des angles d'inclinaison ω dans la plage de 5° à 85° et a des bords courts inclinés dans des directions opposées ; et/ou
chaque cellule de mémoire (2, 3) a l'axe long à un angle θ dans la plage de 1° à 85° et est incliné dans des directions opposées ; ou
une cellule de mémoire (2, 3) a un angle d'inclinaison ω dans la plage de 5° à 85° et l'autre cellule a un angle θ dans la plage de 1° à 85°.

2. Mémoire magnétique selon la revendication 1, dans laquelle la couche intercalaire (7) est non conductrice.

3. Mémoire magnétique selon la revendication 1, dans laquelle la couche intercalaire (7) est conductrice.

4. Mémoire magnétique selon la revendication 1, dans laquelle la couche ferromagnétique modifiable magnétiquement (4) de la première cellule de mémoire (2) de la cellule-paire comprend un matériau ferromagnétique différent de la couche ferromagnétique modifiable magnétiquement de la deuxième cellule de mémoire (3) de la cellule-paire.

5. Mémoire magnétique selon la revendication 1, dans laquelle la couche ferromagnétique modifiable magnétiquement (4) de la première cellule de mémoire (2) de la cellule-paire a une épaisseur différente de l'épaisseur de la couche ferromagnétique modifiable magnétiquement de la deuxième cellule de mémoire (3) de la cellule-paire.

6. Mémoire magnétique selon la revendication 1, dans laquelle la couche ferromagnétique modifiable magnétiquement (4) de la première cellule de mémoire (2) de la cellule-paire a un moment magnétique de saturation différent de la couche ferromagnétique modifiable magnétiquement de la deuxième cellule de mémoire (3) de la cellule-paire.

7. Mémoire magnétique selon la revendication 1, dans laquelle la couche ferromagnétique modifiable magnétiquement (4) de la première cellule de mémoire (2) de la cellule-paire a une anisotropie magnétocristalline différente de la couche ferromagnétique modifiable magnétiquement de la deuxième cellule de mémoire (3) de la cellule-paire.

8. Mémoire magnétique selon la revendication 1, dans laquelle les première et deuxième cellules de mémoire (2, 3) de la cellule-paire ont un profil de cellule différent.

9. Mémoire magnétique selon la revendication 1, dans laquelle les première et deuxième cellules de mémoire (2, 3) ont un profil quadrilatéral et une longueur de chaque cellule de mémoire (2, 3) est supérieure à une largeur de la cellule de mémoire.

10. Mémoire magnétique selon la revendication 9, dans laquelle les extrémités courtes de chacune des première et deuxième cellules de mémoire (2, 3) sont écartées angulairement de l'axe long de la cellule de mémoire, avec des angles inférieurs à 90°.

11. Mémoire magnétique selon la revendication 10, dans laquelle les angles sont dans la plage d'environ 5° à 85°.

12. Mémoire magnétique selon la revendication 9, dans laquelle la première cellule de mémoire (2) de la cellule-paire a ses extrémités courtes décalées angulairement dans une direction au-dessus d'un plan horizontal, alors que la deuxième cellule de mémoire (3) de la cellule-paire a ses extrémités courtes décalées angulairement dans une direction opposée au-dessous du plan horizontal.

13. Mémoire magnétique selon la revendication 9, dans laquelle une intersection d'un côté long avec un côté court dans au moins une des première et deuxième cellules de mémoire (2, 3) est arrondie pour supprimer une nucléation de domaine magnétique.

14. Mémoire magnétique selon la revendication 9, dans laquelle le côté long de chacune des première et deuxième cellules de mémoire (2, 3) est écarté angulairement d'un plan horizontal.

15. Mémoire magnétique selon la revendication 14, dans laquelle l'axe long de la première cellule de mémoire (2) de la cellule-paire est décalé angulairement au-dessus du plan horizontal, alors que l'axe long de la deuxième cellule de mémoire (3) de la cellule-paire est décalé angulairement dans une direction opposée par rapport à l'axe long de la première cellule de mémoire, au-dessous du plan horizontal.

16. Mémoire magnétique selon la revendication 15, dans laquelle l'axe long de la première cellule de mémoire (2) est à un angle dans la plage d'environ 1° à 85°, alors que l'axe long de la deuxième cellule de mémoire (3) est à un angle dans la plage d'environ -1° à -85°.

17. Mémoire magnétique selon la revendication 9, dans laquelle la première cellule de mémoire (2) de la cellule-paire a ses extrémités courtes décalées angulairement dans une direction au-dessus d'un plan horizontal, alors que l'axe long de la deuxième cellule de mémoire (3) est décalé angulairement au-dessous du plan horizontal.

18. Mémoire magnétique selon la revendication 9, dans laquelle la première cellule de mémoire (2) de la cellule-paire a ses extrémités courtes décalées angulairement dans une direction au-dessous d'un plan horizontal, alors que l'axe long de la deuxième cellule de mémoire (3) est décalé angulairement au-dessus du plan horizontal.

19. Mémoire magnétique selon la revendication 1, dans laquelle les première et deuxième cellules de mémoire (2, 3) sont séparées par une distance d'au moins la moitié de la largeur d'une cellule pour minimiser le couplage magnétostatique entre les cellules.

20. Mémoire magnétique selon la revendication 1, dans laquelle les première et deuxième cellules de mémoire (2, 3) de la cellule-paire partagent une même ligne de courant orthogonale.

21. Mémoire magnétique selon la revendication 1, dans laquelle les première et deuxième cellules de mémoire (2, 3) de la cellule-paire ont un transistor partagé pour l'opération de détection.

22. Mémoire magnétique selon la revendication 1, dans laquelle un rapport de longueur-largeur de chaque cellule (2, 3) est entre 1,1 et 5,0.

23. Mémoire magnétique selon la revendication 22, dans laquelle les première et deuxième cellules de mémoire (2, 3) de la cellule-paire ont un rapport longueur-largeur différent.

24. Mémoire magnétique selon la revendication 1, dans laquelle la couche ferromagnétique modifiable magnétiquement (4) comprend un alliage de Ni, Fe et Co, ou une combinaison de ceux-ci.

25. Mémoire magnétique selon la revendication 1, dans laquelle les première et deuxième cellules de mémoire (2, 3) ont chacune une pluralité de couches ferromagnétiques modifiables magnétiquement, une des couches ferromagnétiques modifiables magnétiquement au niveau d'un dessous de la structure et une autre au niveau d'un dessus de la structure.

26. Mémoire magnétique selon la revendication 25, dans laquelle chaque couche ferromagnétique modifiable magnétiquement mémorise un bit d'informations binaires.

27. Mémoire magnétique selon la revendication 25, comprenant deux cellules-paires, dans laquelle chaque cellule-paire mémorise deux bits d'informations binaires.

28. Mémoire magnétique selon la revendication 27, comprenant quatre cellules-paires, avec deux cellules-paires empilées l'une sur l'autre dans une configuration orthogonale, formant une structure de cellules à huit bits.

29. Mémoire magnétique selon la revendication 28, dans laquelle un axe de champ d'excitation de précession de spin pour quatre bits de dessous est perpendiculaire aux quatre bits de dessus, de manière que quand les quatre bits de dessous sont excités pour la précession, les quatre bits de dessus ne sont pas excités pour la précession.

30. Mémoire magnétique selon la revendication 28, dans laquelle un axe de champ d'excitation de précession de spin pour quatre bits de dessous est perpendiculaire aux quatre bits de dessus, de manière que quand les quatre bits de dessus sont excités pour la précession, les quatre bits de dessous ne sont pas excités pour la précession.

31. Mémoire magnétique selon la revendication 1, dans laquelle les première et deuxième cellules de mémoire (2, 3) de la cellule-paire ont une fréquence de précession de spin différente.

32. Mémoire magnétique selon la revendication 1, dans laquelle les première et deuxième cellules de mémoire (2, 3) de la cellule-paire ont une constante d'amortissement magnétique différente pour permettre une dissipation d'énergie magnétique.

33. Procédé d'écriture pour une mémoire magnétique comprenant au moins des première et deuxième cellules de mémoire (2, 3) disposées à l'intersection d'une intersection unique d'une ligne de mot (2) et d'une ligne de bit (1), où chaque cellule de mémoire (2, 3) a des bords courts inclinés avec un angle d'inclinaison ω par rapport à l'axe long de la cellule et avec l'axe long à un angle θ par rapport au plan des lignes de mot et de bit ;
■ chaque cellule de mémoire (2, 3) a des angles d'inclinaison ω dans la plage de 5° à 85° et a des bords courts inclinés dans des directions opposées ; et/ou
■ chaque cellule de mémoire (2, 3) a l'axe long à un angle θ dans la plage de 1° à 85° et est incliné dans des directions opposées ; ou
■ une cellule de mémoire (2, 3) a un angle d'inclinaison ω dans la plage de 5° à 85° et l'autre cellule a un angle θ dans la plage de 1° à 85° ; le procédé consistant à :
■ appliquer un premier champ magnétique au-dessous d'un champ de commutation de la cellule-paire suivant l'axe long des première et deuxième cellules de mémoire (2, 3) ;
■ appliquer un deuxième champ magnétique orthogonal au premier champ magnétique, le deuxième champ magnétique ayant une intensité suffisante pour créer un angle de précession de spin suffisamment grand pour commuter la magnétisation de la première cellule de mémoire (2) de la cellule-paire à une direction opposée, mais une intensité insuffisante pour commuter la magnétisation de la deuxième cellule de mémoire (3) de la cellule-paire ;
dans lequel le deuxième champ magnétique est coupé dès que la magnétisation de la première cellule (2) a effectué la précession pour plus d'environ 1/2 mais moins qu'environ 3/4 du cycle de précession.

34. Procédé d'écriture pour une mémoire magnétique selon la revendication 33, dans lequel le premier champ magnétique est coupé après que le deuxième champ magnétique a été coupé.

35. Procédé d'écriture pour une mémoire magnétique selon la revendication 33, dans lequel une impulsion du premier champ magnétique a une durée supérieure à une impulsion du deuxième champ magnétique.

36. Procédé d'écriture pour une mémoire magnétique selon la revendication 33, dans lequel une impulsion du deuxième champ magnétique a un temps de montée égal ou inférieur à 1 ns.

37. Procédé d'écriture pour une mémoire magnétique selon la revendication 33, dans lequel une des première et deuxième cellules de mémoire est sélectionnée pour l'écriture en changeant la polarité du deuxième champ magnétique.

38. Procédé d'écriture pour une mémoire magnétique selon la revendication 36, dans lequel une impulsion du deuxième champ magnétique est d'un profil qui génère un champ montant rapide.

39. Procédé d'écriture pour une mémoire magnétique selon la revendication 38, dans lequel le profil est l'un parmi trapézoïdal ou exponentiel.

40. Procédé d'écriture pour une mémoire magnétique selon la revendication 33, consistant en outre à détecter des informations mémorisées dans chaque cellule en utilisant un effet de magnétorésistance.

41. Procédé d'écriture pour une mémoire magnétique selon la revendication 33, consistant en outre à terminer le deuxième champ magnétique quand la magnétisation de la première cellule de mémoire a passé (n + 1/2) cycles de précession, où n est le nombre de cycles de précession.

42. Procédé d'écriture pour une mémoire magnétique selon la revendication 33, dans lequel la magnétisation des première et deuxième cellules de mémoire est commutée en appliquant un champ magnétique externe, en utilisant un courant polarisé de spin, ou une combinaison de ceux-ci.

43. Procédé d'écriture pour une mémoire magnétique selon la revendication 33, dans lequel une intensité d'impulsion du premier champ magnétique est la même ou différente en commutant chaque bit dans la cellule-paire.

44. Procédé d'écriture selon la revendication 33, dans lequel une durée d'impulsion du premier champ magnétique est dans une plage d'environ 0,2 à 10 ns alors qu'une durée d'impulsion du deuxième champ magnétique est dans une plage d'environ 0,01 à 5 ns.
